# EUROPEAN PATENT APPLICATION

(11) **EP 4 800 477 A1**
(43) Date of publication of application: **02.09.2026**
(21) Application number: 25160191.0
(22) Date of filing: 26.02.2025
(51) Int. Cl.: G03F 7/00

(54) **IMPROVEMENTS TO LITHOGRAPHIC METHODS AND APPARATUS**

(71) Applicant: ASML Netherlands B.V., 5500 AH Veldhoven (NL)
(72) Inventor: MITRIAS, Christos, 5500 AH Veldhoven (NL); DE WINTER, Laurentius, Cornelius, 5500 AH Veldhoven (NL); MCNAMARA, John, Martin, 5500 AH Veldhoven (NL)
(74) Representative: ASML Netherlands B.V.

(57) **Abstract**

A method of forming a feature on a substrate. The method comprises performing an exposure process comprising projecting an image of the feature in the vicinity of the substrate. The method comprises adjusting a focal position of the image relative to a top surface of the substrate during the exposure process. The method comprises adjusting an intensity of the image during the exposure process.

## Description

### FIELD

The present invention relates to new methods of forming a feature on a substrate (for example a silicon wafer). The present invention also relates to a lithographic apparatus operable to carry out one or more of these new methods. The present invention may have particular application to extreme ultraviolet (EUV) lithography.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern from a patterning device (e.g., a mask or a reticle) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 2-20 nm, for example 6.7 nm or 13.5 nm, may be used to form smaller features on a substrate than a lithographic apparatus which uses, for example, radiation with a wavelength of 193 nm.

It may be desirable to provide new, alternative apparatus and/or methods for improving imaging performance within a lithographic apparatus that at least partially addresses one or more problems associated with prior art arrangements whether identified herein or otherwise.

### SUMMARY

According to a first aspect of the present disclosure there is provided a method of forming a feature on a substrate. The method comprises performing an exposure process comprising projecting an image of the feature in the vicinity of the substrate. The method comprises adjusting a focal position of the image relative to a top surface of the substrate during the exposure process. The method comprises adjusting an intensity of the image during the exposure process.

The method may comprise a semiconductor manufacturing method. The method may comprise a lithographic method. The substrate may comprise a resist-coated silicon wafer.

The method according to the first aspect of the present disclosure may be particularly advantageous for forming isolated features on a substrate such as isolated contacts and isolated spaces.

The method according to the first aspect of the present disclosure may be particularly advantageous for forming bright features in a dark environment (i.e. dark-field exposures). The method may also be used, and provide advantages in, forming dark features in a bright environment (i.e. light-field exposures).

The method according to the first aspect of the present disclosure may advantageously increase a minimum value of normalized image log-slope (NILS), which is a commonly used as a measure for contrast, through the vicinity of the substrate (e.g. through a photoresist stack). The method according to the first aspect of the present disclosure may advantageously reduce a variation of NILS through the vicinity of the substrate.

NILS is a commonly used measure for contrast and is defined as the log-slope of the aerial-image at threshold, normalized with the target-critical dimension (CD). That is, NILS is given by: $NILS = \frac{{CD}_{target}}{th} {\left(\frac{dI}{dx}\right)}_{th} ,$ where *th* is a threshold.

The method according to the first aspect may improve a depth of focus of features formed on the substrate (relative to an exposure wherein the focal position of the image is not adjusted relative to a top surface of the substrate during exposure and/or an intensity of the image is not adjusted during exposure). The method according to the first aspect may improve a process window of the exposure process (e.g. a lithographic process window). For example, the method according to the first aspect may enable a desired exposure characteristic (e.g. a desired accuracy of critical dimension, sidewall angle, etc.) to be achieved using a greater range (i.e. improved tolerance) of one or more exposure parameters (e.g. such as focus and dose).

Depth of focus may be defined as a range of focus values (e.g. Z positions) across which a resist profile of a given feature (e.g. a sidewall angle and/or critical dimension) is within all desired limits or specifications.

One known method for improving the depth of focus of features in scanning lithographic apparatus (also known as scanners) is known as focus drilling. Focus drilling involves a scanning motion of the substrate (wafer) such that a plane of best focus of the aerial image moves (in a direction perpendicular to the wafer) during the scanning motion. That is, it involves a single continuous exposure wherein a focal position of the image varies continuously during the scanning motion. This results in an aerial image that is smeared out in the focus direction and consequently has a larger depth of focus. One consequence of this is that the contrast of the image is reduced. Some known techniques for performing focus drilling can be technically complicated or challenging such as, for example, varying focal positon by varying a wavelength or bandwidth of exposure radiation (e.g. in deep ultraviolet DUV lithographic processes).

Advantageously, the method according to the first aspect, which may be referred to as focus-dose-drilling or focus-intensity-drilling, can achieve an increased depth of focus (relative to an exposure wherein the focal position of the image relative to the top surface of the substrate is not adjusted and/or an intensity of the image is not adjusted) whilst resulting in less loss of contrast over a desired focus-range compared to traditional focus drilling (i.e. focus-only drilling). The increased depth of focus (relative to an exposure wherein the focal position of the image relative to the top surface of the substrate is not adjusted and/or an intensity of the image is not adjusted) may be greater than that achieved with traditional focus-only drilling.

The focal position of an image may be defined as a position of a plane of best focus of the image. The focal position of an image may be define as a position in a vertical or Z direction when the substrate is positioned in a horizontal or X-Y plane.

The intensity of the image may be adjusted in at least partial dependence upon the adjustment to the focal position.

Adjusting the focal position of the image may comprise the top surface of the substrate being disposed at a non-zero angle to a plane of best focus (e.g. introducing a tilt about the x-direction). Adjusting the focal position of the image may comprise adjusting a z-position of the substrate between exposure processes. Adjusting the focal position of the image may comprise adjusting a wavelength or bandwidth of the exposure radiation between exposure processes.

Adjusting the intensity of the image may comprise adjusting a source power of radiation use to form the image. Adjusting the intensity of the image may comprise adjusting an exposure time of the exposure processes. For example, adjusting the intensity of the image may comprise adjusting a movement speed of one or more stages (such as, for example, a substrate table and/or the support structure).

Adjusting the focal position of the image relative to the top surface of the substrate during the exposure process may comprise projecting the image at a first focal position. Adjusting the focal position of the image relative to the top surface of the substrate during the exposure process may comprise projecting the image at a second focal position that is different to the first focal position. Adjusting the intensity of the image during the exposure process may comprise applying a first intensity at the first focal position. Adjusting the intensity of the image during the exposure process may comprise applying a second intensity at the second focal position that is different to the first intensity.

The second focal position may be closer to the substrate than the first focal position. The second intensity may be greater than the first intensity. This may advantageously at least partially account for increased attenuation of the image at greater focal positions (i.e. deeper locations in a resist). This may be particularly beneficial when aiming to form features having substantially vertical walls in the resist (i.e. when aiming to achieve a sidewall angle of substantially 90° through the resist).

The second focal position may be closer to the substrate than the first focal position. The second intensity may be less than the first intensity. This may advantageously introduce intentional variation of a profile of the feature. For example, intentional variation of sidewall angle may be desired in some circumstances (e.g. to account for post-exposure processing effects such as, for example etching effects).

Adjusting a focal position of the image relative to the top surface of the substrate during the exposure process may comprise forming an illumination region having a variable focal position profile. Adjusting an intensity of the image during the exposure process may comprise forming the illumination region having a variable intensity profile. Performing the exposure process may comprise performing a single exposure through the illumination region.

The exposure process may comprise performing a plurality of sequential exposures. Each of the plurality of exposures may comprise projecting an image of the feature in the vicinity of the substrate. The focal position of the image relative to the top surface of the substrate may be different for at least two of the plurality of exposures. There may be a range of focal positions of the image relative to the top surface of the substrate that is not used during any of the plurality of exposures and which lies between the focal positions of the image relative to the top surface of the substrate for the two of the plurality of exposures. The intensity of the image may be different for the at least two of the plurality of exposures. There may be a range of intensities of the image that is not used during any of the plurality of exposures and which lies between the different intensities of the image for the two of the plurality of exposures.

Two sequential exposures may be performed.

It will be appreciated that there may be some (for example relatively small) variation of a focal position of the image relative to the top surface of the substrate during any of the plurality of exposures. For such embodiments, the ranges of focal positions of the images relative to the top surface of the substrate for at least two of the plurality of exposures may be different, non-overlapping and separated.

The plurality of sequential exposures may be temporally separate (for example, there may be a time period between two such sequential exposures). This may allow for the substrate to be moved relative to a plane of best focus between two such sequential exposures.

A range of focal positions of the image relative to the top surface of the substrate during any one of the plurality of exposures may be less than a difference between average focal positions of that exposure and an adjacent exposure when the exposures are ordered by the average focal position of the image relative to the top surface of the substrate.

Performing the exposure process may comprise illuminating a patterning device with radiation. Performing the exposure process may comprise capturing radiation scattered from the patterning device with imaging optics. Performing the exposure process may comprise projecting the scattered radiation onto the substrate so as to form an image of the patterning device in the vicinity of the substrate. Scattering may comprise reflection and/or diffraction. Scattered radiation may comprise reflected radiation and/or diffracted radiation.

The patterning device may be referred to as a reticle or a mask. The patterning device may be disposed in an object plane of the imaging optics. The substrate may be disposed in, or close to an image plane of the imaging optics. The object plane is optically conjugate to the image plane. The object plane, the image plane (and any other optically conjugate planes) may be referred to as field planes of the imaging optics.

Performing the exposure process may comprise illuminating a plurality of discrete portions of an illumination region in an object plane. The plurality of discrete portions may be at different positions in a first direction. Performing the exposure process may comprise moving a patterning device having the feature through the illumination region in the first direction. Performing the exposure process may comprise moving the substrate such that an image of the patterning device is substantially static with respect to the substrate in the first direction. A surface of the substrate may be disposed at a non-zero angle to a plane of best focus in a plane containing the first direction.

One or more exposures may be performed by a scanning exposure wherein only a plurality of discrete portions of a field plane are illuminated. The first direction may be referred to as a scanning direction. The first direction may be referred to as a y-direction in a Cartesian coordinate system. For such embodiments, the surface of the substrate being disposed at a non-zero angle to a plane of best focus in a plane containing the first direction may be referred to as an Rx tilt (i.e. a tilt about the x-direction). Alternatively, adjusting the focal position of the image may comprise adjusting a z-position of the substrate between exposure processes. Alternatively, adjusting the focal position of the image may comprise adjusting a wavelength or bandwidth of the exposure radiation between exposure processes.

It will be appreciated that in order to move the substrate in the first direction such that an image of the patterning device is substantially static with respect to the substrate in the first direction, the movement will in general be dependent on the characteristics of the imaging system. For example, if the imaging system forms an inverted image of the patterning device then the substrate will be moved in the opposite direction in the first direction to the patterning device. In addition, a speed of movement of the substrate will be dependent in the speed of the patterning device and any optical magnification factor applied by the imaging system in the first direction.

As the feature moves through one of the plurality of discrete portions of the illumination region that are illuminated, an image of the feature may be formed and one of a plurality of exposures may be performed.

Since the surface of the substrate may be disposed at a non-zero angle to a plane of best focus in a plane containing the first direction, as the substrate moves in the first direction, the plane of best focus moves relative to the surface of the substrate. As a result, a focal position of the image relative to the top surface of the substrate is different for each of the plurality of plurality of exposures.

The number of sequential exposures that are performed may, in general, be at least partly dependent on: (a) an extent of the aerial image of the feature in the focus direction, and/or (b) a desired depth of focus.

The plurality of discrete portions may be separated in the first direction. This may result in an improved contrast performance.

The intensity of the image may be adjusted to control a profile of the feature on the substrate. For example, the intensity of the image may be adjusted to control a profile of a feature formed in a photoresist applied to the substrate. Examples of profile characteristics that may be controlled include sidewall angle and/or critical dimension.

The intensity of the image may be adjusted to control a sidewall angle of the feature on the substrate.

The intensity of the image may be adjusted to reduce a variation of the sidewall angle of the feature on the substrate.

The intensity of the image may be adjusted in at least partial dependence upon an expected effect of a post-exposure substrate processing step.

The method may further comprise performing a second exposure process comprising projecting a second image of a second feature in the vicinity of the substrate. The method may further comprise adjusting a focal position of the second image relative to the top surface of the substrate during the second exposure process. The method may further comprise adjusting an intensity of the second image during the second exposure process. The intensity of the image and/or the intensity of the second image may be adjusted to apply different sidewall angles to the feature and the second feature on the substrate.

The intensity of the image may be adjusted to increase a minimum normalized image log-slope of the image of the feature in the vicinity of the substrate. The intensity of the image may be adjusted to reduce a variation of a normalized image log-slope of the image of the feature in the vicinity of the substrate.

The method may comprise using optical simulation software to determine the adjustment to the intensity of the image.

The feature may comprise an isolated feature. For example, the feature may be an isolated contact or an isolated space. The feature may comprise a bright feature (i.e. a feature wherein radiation is transmitted) on a dark background. The feature may comprise a dark feature (i.e. a feature wherein radiation is not transmitted) on a bright background.

The intensity of the image may be adjusted in at least partial dependence on a thickness of a photoresist applied to the substrate. The intensity of the image may be adjusted in at least partial dependence on an absorption coefficient of the photoresist applied to the substrate.

The substrate may comprise a semiconductor.

According to a second aspect of the present disclosure there is provided a lithographic apparatus operable to perform the method of the first aspect of the present disclosure.

The lithographic apparatus may comprise an illumination system. The illumination system may comprise a first optical component comprising a two-dimensional array of independently movable reflective optical elements which is arranged to receive radiation from a radiation source. The illumination system may comprise a second optical component comprising a two-dimensional array of independently movable reflective optical elements and which is arranged to receive radiation from the first optical component and to direct it to an illumination region. The lithographic apparatus may be operable to control the first and second optical components to contribute to performing the method of the first aspect.

Each of the independently movable reflective optical elements of the first optical component may comprise a micro-electromechanical system (MEMS) micro-mirror. Therefore, the first optical component may be considered to comprise a MEMS micro-mirror array.

Each of the independently movable reflective optical elements of the second optical component may comprise a micro-electromechanical system (MEMS) micro-mirror. Therefore, the second optical component may be considered to comprise a MEMS micro-mirror array.

The lithographic apparatus may further comprise a support structure configured to support a patterning device such that the patterning device is disposed in, or is movable through, the illumination region.

The lithographic apparatus may further comprise a substrate table configured to support a substrate. The lithographic apparatus may further comprise a projection system comprising imaging optics configured to receive radiation from the illumination region and to form an image of an object disposed in the illumination region on a substrate supported by the substrate table.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A schematically shows a generally circular portion of the field facet mirror device of the lithographic system shown in Figure 1, showing a central obscuration portion and two portions which receive radiation;
- Figure 2B shows an example shape of a field facet for a faceted field mirror device in a known EUV lithographic apparatus of the form shown in Figure 1;
- Figure 3A schematically shows a new method of forming a feature on a substrate (for example a wafer);
- Figure 3B schematically shows another new method of forming a feature on a substrate (for example a wafer);
- Figure 4A is a schematic representation of an aerial image formed during a single exposure wherein the focal position of the image is not adjusted relative to the top surface of the substrate;
- Figure 4B is a schematic representation of two aerial images which may be formed using the new method shown in Figure 3A;
- Figure 4C shows a line which represents a region which corresponds to a dose of radiation that is sufficient to cause a change in a photoresist on a wafer when the two aerial images shown in Figure 4B are combined;
- Figure 4D is a schematic representation of an aerial image which may be formed using the new method shown in Figure 3B;
- Figure 5 schematically shows a plurality of sub-steps that each of a plurality of exposures of the new method shown in Figure 3A may comprise;
- Figure 6A shows an aerial image formed in resist without any focus drilling;
- Figure 6B shows an aerial image formed in resist using focus-intensity-drilling in accordance with the present disclosure.;
- Figure 7A shows a comparison of the minimum values of NILS achieved through a resist for three different exposure processes;
- Figure 7B shows a comparison of the range of NILS achieved through a resist for the three different exposure processes of Fig. 7A;
- Figure 8A shows a variation of sidewall angle across different values of dose and focal position for an exposure process involving no focus drilling.
- Figure 8B shows a variation of sidewall angle across different values of dose and focal position for an exposure process involving focus-intensity-drilling in accordance with the present disclosure;
- Figure 9 shows an example of how sidewall angle may be controlled using the focus-intensity-drilling technique of the present disclosure

### DETAILED DESCRIPTION

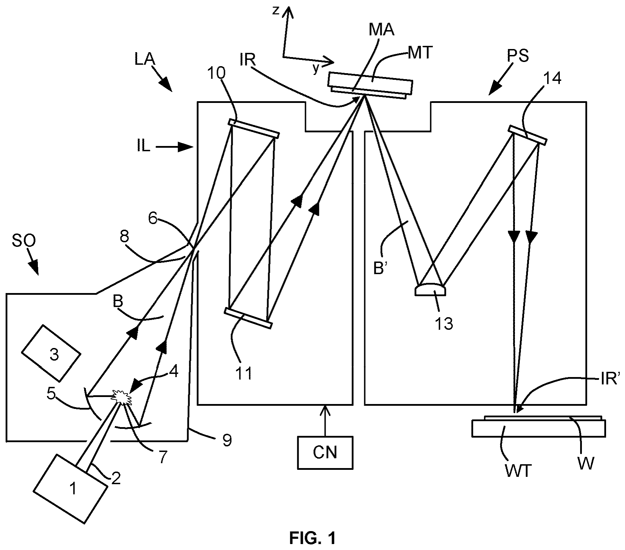

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The faceted field mirror device 10 and the faceted pupil mirror device 11 are arranged to provide a desired angular distribution of the radiation beam B, at the patterning device MA, as well as a desired uniformity of radiation intensity at the patterning device MA. The illumination system IL may be arranged to provide Kohler illumination of an illumination region IR (that the patterning device MA may be moved through during exposure of a substrate W) such that the plasma at the plasma formation region 4 is out of focus (and therefore does not influence properties of the radiation beam) at the patterning device MA and in the conjugate plane of the substrate W. As used herein, the illumination region IR may also be referred to as the illumination slit or the slit.

The illumination region IR is in a field plane in which the reticle MA is disposed during a lithographic exposure. Therefore, the illumination region IR may be referred as a reticle-level or object-level illumination region IR. It will be appreciated that the projection system PS forms an image IR' of the illumination region IR in the plane of the substrate W. The image IR' of the illumination region IR in the plane of the substrate W may be referred to as a wafer-level or image-level illumination region IR'. As used herein, the wafer-level illumination region IR' may also be referred to as the slit.

In lithography, the illumination of the patterning device MA is very important. In particular, it is desirable to control the angular distribution of the radiation at the illumination region IR where the patterning device MA is exposed to radiation. This angular distribution of the radiation is conveniently described in terms of the spatial distribution of the radiation in an illumination pupil plane, which describes how a cone of light that is incident on each point on the patterning device MA is filled.

The uniformity of the illumination is also very important. The uniformity of illumination affects the uniformity of dose to which the target portion of the substrate W is exposed, which affects critical dimension uniformity (CDU), an important measure of the uniformity of the dimension of features formed on the substrate W. For example, it may be desirable to maintain a desired spatial intensity distribution of radiation across the illumination region IR. As used herein the spatial intensity distribution of radiation across the illumination region IR may be referred to as the slit profile.

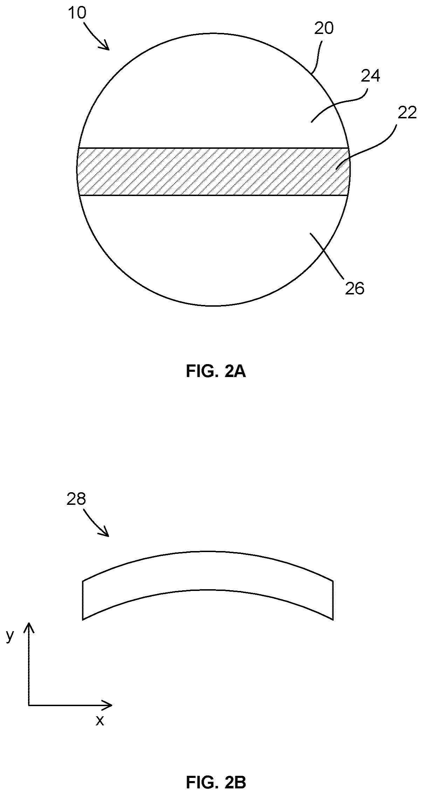

The collector 5 is generally of the form of a concave mirror, which is arranged to collect the radiation which is emitted from the plasma formation region 4 into a solid angle subtended by the collector 5. This radiation is reflected and focused at the intermediate focus 6. As a result, within the housing, the radiation beam B is generally of the form of a converging cone of radiation, which converges at the intermediate focus 6, an outer edge of this cone being indicated in Figure 1 by two lines. Downstream of the intermediate focus 6, the radiation beam B is generally of the form of a diverging cone of radiation, which is incident on the generally circular field facet mirror device 10. However, the radiation source SO may comprise an obscuration that will block a portion of this radiation cone such that there will be some portion of the diverging cone of radiation that will not receive radiation from the collector 5. For example, the radiation source SO may comprise a shield (not shown) which may be arranged to prevent the laser beam 2 from propagating through the opening 8 and into the lithographic apparatus LA (where it may damage optical components). This shield may be supported by the enclosing structure via a support (not shown). Together, the shield and the support form an obscuration of the radiation source SO. Therefore, as indicated schematically in Figure 2A a generally circular portion 20 of the field facet mirror device 10 may comprise a central portion 22, which coincides with the obscuration of the radiation source SO and does not receive any radiation, and two portions 24, 26 which do receive radiation. It will be appreciated that this is schematic and that the obscuration may have any shape or configuration.

It has been proposed to use a faceted field mirror device 10 having a large number of individually directable or movable reflective optical elements so as to provide better control over the illumination modes of the lithographic apparatus LA. It has been further proposed to use a faceted pupil mirror device 11 having a large number of individually directable or movable reflective optical elements so as to provide better control over the illumination modes of the lithographic apparatus LA.

Each of the independently movable reflective optical elements may comprise a micro-electromechanical system (MEMS). Therefore, the faceted field mirror device 10 and/or the faceted pupil mirror device 11 may be considered to comprise a MEMS micro-mirror array.

Each of the reflective optical elements may, for example, be a multilayer mirror. Each of the reflective optical elements may be configured such that its orientation can be controlled about one or two axes so that a direction to which it directs radiation can be controlled. For example, each of the reflective optical elements may have one or more actuators by which the reflective optical element can be rotated about an axis or two orthogonal axes. Thereby, each of the reflective optical elements can be controlled to direct radiation in a specific direction.

The faceted field mirror device 10 may comprise of the order of 100,000 independently movable reflective optical elements. These reflective optical elements may substantially cover the portions 24, 26 of the faceted field mirror device 10 that receive radiation from the radiation source SO (see Figure 2A and accompanying discussion).

In some known lithographic apparatus, such a faceted field mirror device 10 comprising a MEMS micro-mirror array is used as follows. The two-dimensional array of independently movable reflective optical elements provided on the faceted field mirror device 10 may be considered to comprise a plurality of groups of reflective optical elements. Each group of reflective optical elements may comprise a plurality of adjacent independently movable reflective optical elements on the faceted field mirror device 10. Each of the plurality of groups of reflective optical elements may be referred to as a cluster of reflective optical elements.

Each group of reflective optical elements may be configured generally to replace one of the field facets discussed above. For example, each group may cover a region of the faceted field mirror device 10 that generally corresponds to the shape of a field facet of the known faceted field mirror device 10 discussed above (for example a region having a shape generally the same as the shape 28 shown in Figure 2B). It will be appreciated that each of the reflective optical elements may be generally square or rectangular in shape and therefore if the group is arranged as a generally curved elongate region of the faceted field mirror device 10 (similar to the shape 28 shown in Figure 2B), the shape may have jagged or pixelated edges along the curved sides of the shape. Furthermore, the orientations of the reflective optical elements within each group may be configured so as to provide an equivalent optical power or concave shape to a field facet of an existing faceted field mirror device 10.

Each of the plurality of groups may be referred to as a field facet mirror or a virtual field facet mirror. There may be of the order of 100, for example 300, groups of independently movable reflective optical elements. Each group may comprise of the order of 1000 independently movable reflective optical elements. For example, in one embodiment each group may comprise 10 rows of independently movable reflective optical elements, each row having 100 independently movable reflective optical elements.

The plurality of adjacent independently movable reflective optical elements in each group substantially cover a continuous region of the faceted field mirror device 10. It will be appreciated that this may mean that any gaps between adjacent reflective optical elements may be minimal.

A shape of a continuous region of the first optical component covered by the plurality of adjacent independently movable reflective optical elements in a group of independently movable reflective optical elements may be referred to as a shape of that group of independently movable reflective optical elements. The shape of each of the groups of independently movable reflective optical elements may generally correspond to a shape of the illumination region IR (in a similar manner to the shape of each of the field facets described above generally corresponding to a shape of the illumination region IR).

Each of the plurality of groups of independently movable reflective optical elements may have substantially the same size and shape. In some embodiments, the shape of each of the plurality of groups may be curved. In some embodiments, each of the plurality of groups may be generally rectangular in shape.

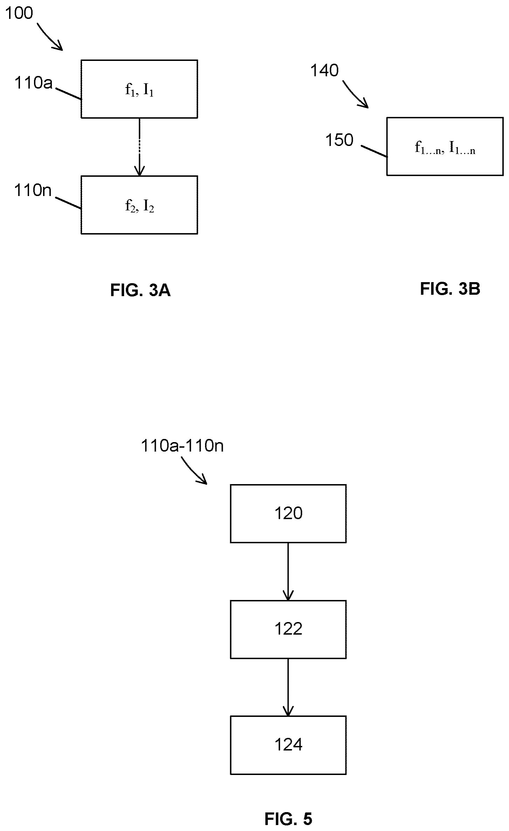

Some embodiments of the present disclosure relate to new methods of forming a feature on a substrate (for example a wafer W). In general, the method comprises performing an exposure process comprising projecting an image of the feature in the vicinity of the substrate. The method involves adjusting a focal position of the image relative to the top surface of the substrate during the exposure process. The method also involves adjusting an intensity of the image during the exposure process. An example of such a new method 100 is now described with reference to Figure 3A.

The new method 100 may comprise performing a plurality of sequential exposures 110a-110n. Performing each of the plurality of exposures 110a-110n may comprise projecting an image of the feature in the vicinity of the substrate W. For example, two sequential exposures may be performed. A focal position f₁, f₂ of the image relative to the top surface of the substrate W is different for at least two of the plurality of exposures 110a-110n. An intensity I₁, I₂ of the image is different for the at least two of the plurality of exposures 110a-110n. Adjusting the intensity of the image may comprise adjusting a source power (e.g. adjusting a power of the radiation source SO of Fig. 1). Alternatively or additionally, adjusting the intensity of the image may comprise adjusting a movement speed of one or more stages (such as, for example, the substrate table WT and/or the support structure MT), thereby adjusting a time for which the image is exposed. There may be a range of focal positions of the image relative to the top surface of the substrate W that is not used during any of the plurality of exposures 110a-110n and which lies between the focal positions f₁, f₂ of the image relative to the top surface of the substrate W for two of the plurality of exposures. There may be a range of intensities of the image that is not used during any of the plurality of exposures 110a-110n and which lies between the different intensities I₁, I₂ of the image for the two of the plurality of exposures.

Figure 3B shows an alternative new method 140 of forming a feature on a substrate (for example a wafer W). In the example of the alternative new method 140, adjusting a focal position of the image relative to the top surface of the substrate during the exposure process may comprise forming an illumination region IR having a variable focal position profile. That is, the focal position f_{1...n} of the image varies at different locations within the slit. In the example of the alternative new method 140, adjusting an intensity of the image during the exposure process may comprise forming the illumination region IR having a variable intensity profile. That is, the intensity of the image I_{1...n} varies at different locations within the slit. In the example of the alternative new method 140, performing the exposure process may comprise performing a single exposure 150 through the illumination region. In this way, both the focal position and the intensity of the image are adjusted during the exposure process by virtue of the illumination region IR having variable focal position and intensity profiles. For example a faceted field mirror device 10 having a large number of individually directable or movable reflective optical elements and/or a faceted pupil mirror device 11 having a large number of individually directable or movable reflective optical elements may be used to form the illumination region IR having variable focal position and intensity profiles f_{1...n}, I_{1...n}.

The new methods 100, 140 may comprise a lithographic method. The new methods 100, 140 may comprise a semiconductor manufacturing method. The substrate W may comprise a semiconductor. The substrate W may comprise a resist-coated silicon wafer.

The new methods 100, 140 shown in Figure 3A and Figure 3B may be particularly advantageous for forming isolated features on a substrate W such as isolated contacts and isolated spaces. In particular, the methods 100, 140 may improve the depth of focus of such features (relative to an exposure wherein the focal position of the image is not adjusted relative to the top surface of the substrate W during exposure and/or relative to an exposure wherein the focal position of the image is adjusted relative to the top surface of the substrate W during exposure but the intensity of the image is not adjusted during the exposure). It will be appreciated that the new methods of the present disclosure may be used to form other types of features.

One known method for improving the depth of focus of such features in scanning lithographic apparatus (also known as scanners) is known as focus drilling (which may be referred to herein is focus-only drilling). Focus drilling involves a scanning motion of the substrate W (wafer) such that a plane of best focus of the aerial image moves (in a direction perpendicular to the wafer W) during the scanning motion. That is, it involves a single continuous exposure wherein a focal position of the image varies continuously during the scanning motion. This results in an aerial image that is smeared out in the focus direction and consequently has a larger depth of focus. One consequence of this is that the contrast of the image is reduced.

According to the Beer-Lambert law, the amount of light transmitted through a medium depends on the thickness of the medium and an absorption coefficient of the medium. In the example of lithography, this leads to a reduced intensity of the aerial image as the aerial image propagates through resist on the substrate W. In the case of traditional focus-only drilling, this means that different focal positions within the resist experience different intensities of aerial image. This can lead to negative results such as unwanted sidewall angle variation and/or critical dimension uniformity errors. By adjusting the intensity of the image for different focal positions, the new methods 100, 140 advantageously account for the attenuation of light through the resist, leading to greater sidewall angle control and critical dimension uniformity through the substrate W compared to traditional focus-only drilling. Advantageously, the new methods 100, 140 can achieve an increased depth of focus compared to traditional focus-only drilling.

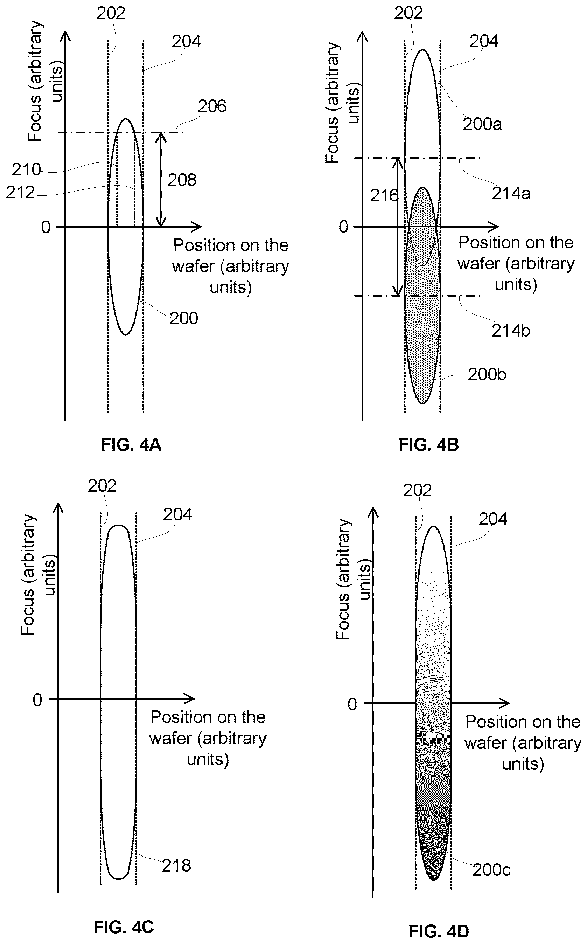

In the example of Fig. 3A, it will be appreciated that there will be at least two sequential exposures 110a, 110b although there may be more than two sequential exposures 110a, 110b-110n. The general principle of the new method 100 will now be discussed with reference to Figures 4A to 4C for an example with just two sequential exposures 110a, 110b.

In general, features may be formed on a substrate, for example a resist-coated silicon, by exposing the substrate to patterned radiation. Some regions on the substrate receive radiation whereas some regions do not (or receive a relatively small amount of radiation). In regions of the substrate which receive radiation in excess of a threshold value, the resist undergoes a change such that during subsequent processing of the substrate these regions will behave differently to those regions which did not receive radiation in excess of the threshold value. For example, either the regions of the substrate which did or did not receive radiation in excess of the threshold value may be more susceptible to etching. In this way, the pattern can be transferred to the substrate W. The size and position of features formed on the wafer W in this way is dependent on the position of the aerial image formed during the exposure process relative to the wafer W.

Figure 4A is a schematic representation of an aerial image 200 formed during a single exposure wherein the focal position of the image is not adjusted relative to the top surface of the substrate W. The aerial image 200 is shown as a function of both focus position (which may be referred to as z-position) and position on the wafer (which may be referred to as an x or y position). The aerial image 200 is represented by an elliptical line which corresponds to a dose of radiation that is sufficient to cause a change in a photoresist on the wafer W. All regions within the line 200 receive a sufficient dose of radiation to cause the resist to undergo a change whereas the regions outside of this do not. It will be appreciated that this is a two dimensional representation for ease of understanding and that the aerial image 200 may be represented by an ellipsoid.

Also shown in Figure 4A are two lines 202, 204, which represent a target dimension or size of the feature represented by the aerial image 200. As can be seen from Figure 4A, when the focus is at 0 (i.e. when a focal position of the aerial image 200 relative to the top surface of the substrate W is aligned with the resist) a dimension of the region of the wafer that falls within the line 200 representing the aerial image matches the target dimension or size of the feature (as represented by lines 202, 204). However, if the focus coincides with line 206 (i.e. the focal position of the aerial image 200 relative to the top surface of the substrate W is misaligned relative to the resist by an amount 208) then a dimension of the region of the wafer that falls within the line 200 representing the aerial image now matches lines 210, 212. This dimension is smaller than the target dimension, representing a printing error.

Figure 4B is a schematic representation of two aerial images 200a, 200b, which may be formed using the new method 100 shown in Fig. 3A. In this simple example, a first aerial image 200a, is formed by a first exposure at a first focal position of the image relative to the top surface of the substrate W, and a second aerial image 200b, is formed by a second exposure at a second focal position of the image relative to the top surface of the substrate W. A focal position of a first one of the two aerial images 200a relative to the top surface of the substrate W is represented by a line 214a and a focal position of a second one of the two aerial images 200a relative to the top surface of the substrate W is represented by a line 214b. As can be seen from Figure 4B, the focal positions of the two aerial images 200a, 200b (which may be formed by two successive exposures 110a, 110b) relative to the top surface of the substrate W are different. Furthermore, there is a range 216 of focal positions of the image relative to the top surface of the substrate W that is not used during any of the two exposures 110a, 110b and which lies between the focal positions 214a, 214b of the image relative to the top surface of the substrate W for the two exposures 110a, 110b. That is, the focal position of the aerial image relative to the top surface of the substrate is adjusted during the exposure process.

The intensity of the aerial image 200a, 200b is adjusted in at least partial dependence upon the adjustment to the focal position 214a, 214b. An intensity of the first aerial image 200a is represented by an elliptical line having a first fill which, in the example of Fig. 4B, is a white fill. An intensity of the second aerial image 200b is represented by an elliptical line having a second fill that is darker than the first fill, thereby indicating a second intensity that is greater than the first intensity. In the example of Fig. 4B, the second fill is grey. That is, in the example of Fig. 4B, adjusting the focal position of the image relative to the top surface of the substrate during the exposure process comprises projecting the image 200a at a first focal position 214a and projecting the image 200b at a second focal position 214b that is different to the first focal position 214a. Adjusting the intensity of the image during the exposure process comprises applying a first intensity (i.e. the white fill) at the first focal position 214a and applying a second intensity (i.e. the grey fill) at the second focal position that is different to the first intensity. In the example of Fig. 4B, the second focal position 214b is closer to the substrate than the first focal position 214a, and the second intensity is greater than the first intensity. As such, attenuation of the aerial image after travelling a greater distance through the resist to reach the second focal position 214b is accounted for. The intensity of the image may be adjusted in at least partial dependence on a thickness of a photoresist applied to the substrate and/or an absorption coefficient of the photoresist applied to the substrate. This may depend on the type of lithographic exposure taking place. For example, a chemically amplified resist used in deep ultraviolet lithographic exposures may have an absorption coefficient of about 1 µm⁻¹ and a thickness of between about 100nm and about 500nm. As another example, a chemically amplified resist used in extreme ultraviolet lithographic exposures may have an absorption coefficient of about 5 µm⁻¹ and a thickness of between about 40nm and about 70nm. As a further example, a metal-oxide resist used in extreme ultraviolet lithographic exposures may have an absorption coefficient of about 15 µm⁻¹ and a thickness of between about 15nm and about 20nm.

Alternatively, the second focal position may be closer to the substrate than the first focal position, and the second intensity may be less than the first intensity. This may advantageously introduce intentional variation of a profile of the feature. For example, intentional variation of sidewall angle may be desired in some circumstances (e.g. to account for post-exposure processing effects such as, for example etching effects).

Figure 4C shows a line 218 which represents a region which corresponds to a dose of radiation that is sufficient to cause a change in a photoresist on the wafer W when the two aerial images 200a, 200b shown in Figure 4B are combined. All regions within the line 218 receive a sufficient dose of radiation to cause the resist to undergo a change whereas the regions outside of this do not. From a comparison of Figures 4C and 4A it is clear that the two exposures represented by the two aerial images 200a, 200b can achieve an increased depth of focus (relative to the single exposure represented by aerial image 200). From a comparison of Figures 4C and 4A, it is also clear that a uniformity profile of the aerial image through the resist is improved by performing an exposure in accordance with the new method 100 of Fig. 3A. This may result in a sidewall angle that is closer to a desired value (e.g. 90°) and/or a reduction in sidewall angle variation through the resist. The advantageous exposure of Fig. 4C may also be achieved by the alternative new method 140 of Fig. 3B.

Sidewall angle may correspond to an angle formed between a wall of a feature and a plane of the substrate. Sidewall angle may correspond to a tangent plane to a point on the substrate. Sidewall angle may apply to features etched in a resist and/or features of a developed resist. In general, it may be desirable to form features having substantially vertical sidewalls (i.e. walls formed at a substantially 90° angle relative to a plane of the substrate W). As patterning critical dimensions become smaller, lithographic process windows also tend to become smaller, and parameters such as sidewall angle and critical dimension may start to depend on each other. In the process of using lithography to form electrical devices, it has been found that sidewall angle correlates better with at least some resulting electrical device parameters compared to traditional control parameters such as critical dimension and normalized image log-slope (NILS). As such, it is beneficial to enable greater sidewall angle control in lithographic processes. The technique of focus-intensity-drilling according to the present invention enables greater control of sidewall angle compared to traditional focus-only drilling.

Figure 4D is a schematic representation of a single aerial image 200c, which may be formed using the alternative new method 140 shown in Fig. 3B. In this simple example, an illumination region IR having a variable focal position profile and a variable intensity profile is formed using, for example, first and second optical components 10, 11 comprising two-dimensional arrays of independently movable reflective optical elements(e.g. micro-electromechanical system (MEMS) micro-mirrors). A single exposure through the illumination region IR is performed. As can be seen from Fig. 4D, the single exposure covers a range of focal positions that substantially corresponds to the combined extent of focal positions covered by the two aerial images 200a, 200b of Fig. 4B. That is, the focal position of the aerial image relative to the top surface of the substrate is adjusted during the exposure process. As can be seen from Fig. 4D, the intensity of the image increases as the focal position goes deeper into the resist and closer to the substrate W. This is shown by the gradient fill of the aerial image 200c, with a lighter fill representing lesser intensities at shallower focal positions and a darker fill representing greater intensities at deeper focal positions. As such, attenuation of the aerial image whilst travelling greater distances through the resist is accounted for. The alternative new method 140 shown in Fig. 3B results in the improved dose of radiation (compared to no focus drilling or traditional focus-only drilling) represented by Fig. 4C.

The focal position of an image may be defined as a position of a plane of best focus of the image. It will be appreciated that there may be some (for example relatively small) variation of a focal position of the image relative to the top surface of the substrate W during any of the plurality of exposures 110a-110n. For such embodiments, the ranges of focal positions of the images relative to the top surface of the substrate W for at least two of the plurality of exposures 110a-110n may be different, non-overlapping and separated.

The plurality of sequential exposures 110a-110n may be temporally separated (for example, there may be a time period between two such sequential exposures). This may allow for the substrate W to be moved relative to a plane of best focus between two such sequential exposures 110a-110n.

The method of adjusting a focal position of the image relative to the top surface of the substrate during the exposure process and adjusting an intensity of the image during the exposure process (i.e. focus-intensity-drilling) may form a part of a lithographic exposure process (e.g. using a lithographic apparatus LA such as that shown in Fig. 1). For example, performing the exposure process may comprise illuminating a patterning device MA with radiation B. Performing the exposure process may comprise capturing radiation B' scattered from the patterning device MA with imaging optics PS. Performing the exposure process may comprise projecting the scattered radiation B' onto the substrate W so as to form an image of the patterning device MA in the vicinity of the substrate W.

Each of the plurality of exposures 110a-110n of the new method 100 shown in Figure 3A may comprise a plurality of sub-steps, as now discussed with reference to Figure 5. Each of the plurality of exposures 110a-110n may comprise a sub-step 120 of illuminating a patterning device MA with radiation B. Each of the plurality of exposures 110a-110n may further comprise a sub-step 122 of capturing radiation B' scattered from the patterning device MA with imaging optics PS. Each of the plurality of exposures 110a-110n may further comprise a sub-step 124 of projecting the scattered radiation B' onto the substrate W so as to form an image of the patterning device MA in the vicinity of the substrate W.

With reference to the alternative new method 140 of Fig. 3B, the single exposure 150 may comprise illuminating a patterning device MA with radiation B. The single exposure 150 may comprise capturing radiation B' scattered from the patterning device MA with imaging optics PS. The single exposure may comprise projecting the scattered radiation B' onto the substrate W so as to form an image of the patterning device MA in the vicinity of the substrate W.

The patterning device MA may be referred to as a reticle or a mask. The patterning device MA may be disposed in an object plane of the imaging optics PS. The substrate W may be disposed in, or close to an image plane of the imaging optics PS. The object plane is optically conjugate to the image plane. The object plane, the image plane (and any other optically conjugate planes) may be referred to as field planes of the imaging optics PS.

Some embodiments of the new methods 100, 140 shown in Figures 3A and 3B may comprise the following steps. The new methods 100, 140 may comprise a step of illuminating an illumination region IR in an object plane. The new methods 100, 140 may comprise a step of moving a patterning device MA having the feature through the illumination region IR in the first direction (i.e. the y-direction). The new methods 100, 140 may comprise a step of moving the substrate W such that an image of the patterning device MA is substantially static with respect to the substrate W in the first direction (i.e. the y-direction). This may involve moving the substrate W through the wafer-level illumination region IR' in the first direction (i.e. the y-direction). That is, the exposure process may comprise a scanning exposure through the illumination region IR. It will be appreciated that steps of moving the patterning device MA and moving the substrate W may be performed simultaneously. It will be appreciated that in order to move the substrate W in the first direction such that an image of the patterning device MA is substantially static with respect to the substrate in the first direction (i.e. the y-direction), the movement will in general be dependent on the characteristics of the imaging system (i.e. the projection system PS). For example, if the imaging system PS forms an inverted image of the patterning device MA then the substrate W will be moved in the opposite direction in the first direction to the patterning device MA. In addition, a speed of movement of the substrate W will be dependent in the speed of the patterning device MA and any optical magnification factor applied by the imaging system PS in the first direction.

During this scanning exposure, a surface of the substrate W may be disposed at a non-zero angle to a plane of best focus in a plane containing the first direction (a plane which may be referred to as a y-z plane). The first direction may be referred to as a y-direction in a Cartesian coordinate system. The first direction (i.e. the y-direction) may be referred to as a scanning direction. For such embodiments, the surface of the substrate W being disposed at a non-zero angle to a plane of best focus in a plane containing the first direction may be referred to as an Rx tilt (i.e. a tilt of the wavefront about the x-direction). Since the surface of the substrate W is disposed at a non-zero angle to a plane of best focus in a plane containing the first direction (i.e. the y-z plane), as the substrate moves in the first direction (the y-direction), the plane of best focus moves relative to the surface of the substrate W. As a result, a focal position of the image relative to the top surface of the substrate W is adjusted during the exposure process.

The number of sequential exposures that are performed by the new method 100 shown in Figure 3A may, in general, be at least partly dependent on: (a) an extent of the aerial image of the feature in the focus direction; and/or (b) a desired depth of focus.

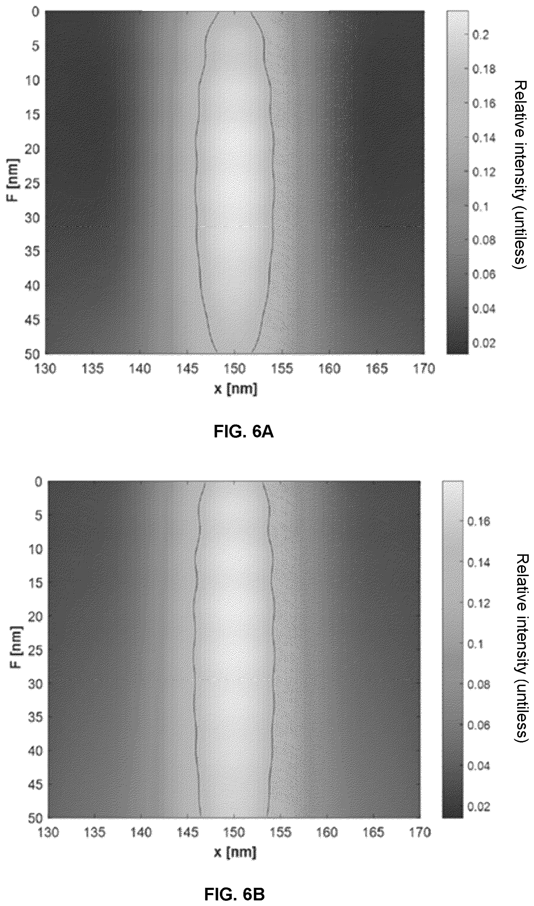

Fig. 6A shows an aerial image formed in resist without any focus drilling. Fig. 6B shows an aerial image formed in resist using focus-intensity-drilling in accordance with the present disclosure. Fig. 6A and Fig. 6B compare the formation of an isolated contact-hole using (Fig. 6A) no focus drilling (i.e. a single exposure at a static focus level); and (Fig. 6B) a two-level focus two-level intensity arrangement (for example of the type discussed above with reference to Figure 3A). The x axes show the x position on the substrate, the y axes show the focal position within the resist (with greater values representing deeper focal positions within the resist) and the shading shows the relative intensity of the aerial image (with lighter shades representing greater intensities). As can be seen on comparison between Fig. 6A and Fig. 6B, there is a clear improvement of the uniformity profile of the aerial image through the resist when using focus-intensity drilling. When no focus drilling is applied, the top and bottom of the resist experience a drastically different intensity profile due to attenuation of light propagating through the resist. In contrast, focus-intensity-drilling significantly decreases the intensity variations of the aerial image through the resist. It can be seen that the threshold dose contours are straighter through focus for the two focus-level two-intensity arrangement (Fig. 6B) than for the no drilling arrangement (Fig. 6A). This means that a larger defocus is allowed before the critical dimension deviates 10% from specification (i.e. achieving an improved depth of focus and lithographic process window).

The intensity of the image may be adjusted to control a profile (e.g. a shape or form) of the feature on the substrate. For example, the intensity of the image may be adjusted to control a profile of a feature formed in a photoresist applied to the substrate. Examples of profile characteristics that may be controlled include sidewall angle and/or critical dimension. For example, as previously described, the technique of focus-intensity-drilling according to the present invention enables greater control of sidewall angle compared to traditional focus-only drilling. Sidewall angle can be tuned through the substrate W by adjusting the focal position and the intensity of the aerial image during the exposure process. This allows a desired sidewall angle distribution throughout the substrate W to be achieved which, when combined with complimentary post-exposure processing settings such as, for example, etch settings, enables a more uniform distribution of parameters such as critical dimension and sidewall angle in the substrate (e.g. silicon). The adjustments to the focal position of the image relative to the top surface of the substrate and/or the intensity of the image during the exposure process may be selected to control a sidewall angle of the feature on the substrate. For example, the intensity of the image may be adjusted to reduce a variation of the sidewall angle of the feature on the substrate.

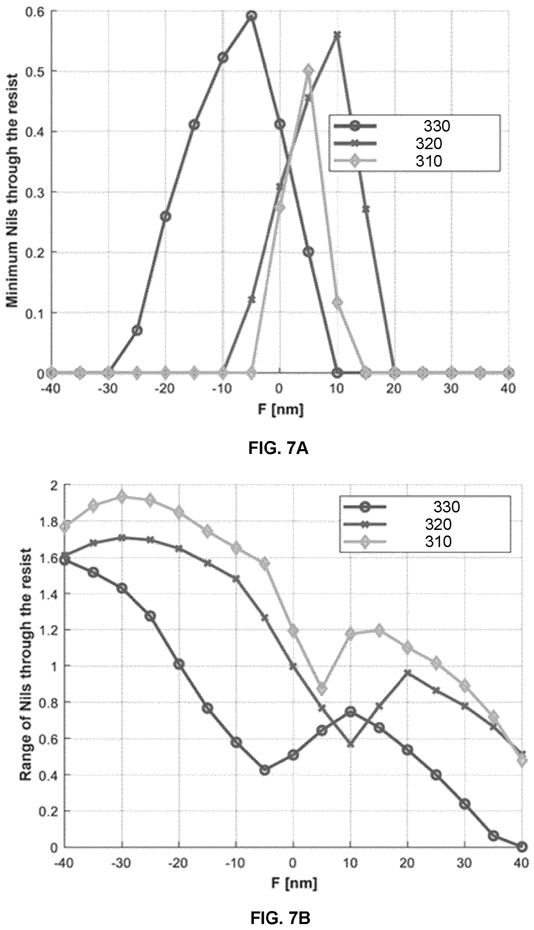

Maintaining a minimum value of NILS through the resist and/or reducing a variation of NILS through the resist may allow greater control of sidewall angle through the resist. Fig. 7A shows a comparison of the minimum values of NILS (unitless) achieved through a resist for three different exposure processes. A first exposure process 310 involves no focus drilling (i.e. neither focal position nor intensity are adjusted during the exposure process). A second exposure 320 involves traditional focus-only drilling (i.e. focal position is adjusted but intensity is not adjusted during the exposure process). A third exposure process 330 involves focus-intensity-drilling in accordance with the present disclosure (i.e. both focal position and intensity are adjusted during the exposure process). The Y axis shows the minimum value of NILS through the resist and the x axes shows different values of defocus error. Parameters such as, for example, optical aberrations and/or substrate warping or "unflatness" can result in the image being out of focus and thereby contribute to the defocus error. The area under each line corresponds to the defocus range across which a minimum value of NILS can be maintained during each exposure process. The first exposure process 310 has the smallest area, and therefore is only capable of maintaining a minimum value of NILS across a relatively small range of defocus values. That is, the first exposure process has the least tolerance for defocus errors. In contrast, the third exposure process 330 has the greatest area, and therefore is capable of maintaining a minimum value of NILS across the greatest range of defocus values. That is, the focus-intensity-drilling exposure process 330 of the present disclosure has the greatest tolerance for defocus errors. This advantageously provides a greater range of focus and/or process window in which key printing parameters such as, for example, sidewall angle are within desired limits.

Fig. 7B shows a comparison of the range of NILS (unitless) achieved through a resist for the three different exposure processes of Fig. 7A. The first exposure process 310 involves no focus drilling (i.e. neither focal position nor intensity are adjusted during the exposure process). The second exposure 320 involves traditional focus-only drilling (i.e. focal position is adjusted but intensity is not adjusted during the exposure process). The third exposure process 330 involves focus-intensity-drilling in accordance with the present disclosure (i.e. both focal position and intensity are adjusted during the exposure process). The Y axis shows the range of NILS through the resist and the x axes shows different values of defocus error. As can be seen, the first exposure process 310 involves the greatest variation of NILS through the resist. In contrast, the third exposure 330 involves the least variation of NILS through the resist. In cases for which low variation of sidewall angle is desired (e.g. when trying to form a feature having substantially vertical walls) the focus-intensity-drilling exposure process 330 of the present disclosure provides the smallest variation of NILS through the resist. In cases for which intentional variation of sidewall angle is desired (e.g. to account for post-exposure processing effects such as, for example etching effects) the focus-intensity-drilling exposure process 330 of the present disclosure provides the greatest range across which sidewall angle may be controlled.

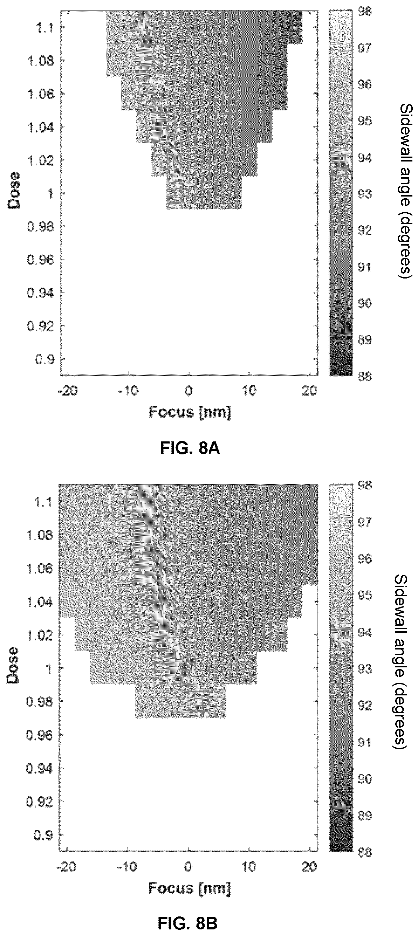

By varying the values of focal position and intensity (e.g. by varying focal position ratios and/or intensity ratios between different exposures and/or different locations through the illumination region) a large range of sidewall angles can be achieved. Fig. 8A shows a variation of sidewall angle across different values of dose and focal position for an exposure process involving no focus drilling. Fig. 8B shows a variation of sidewall angle across different values of dose and focal position for an exposure process involving focus-intensity-drilling in accordance with the present disclosure. The areas covered by the populated portions of the graphs of Fig. 8A and 8B represent the range of focus and does values across which the intensity of the image is above the threshold for forming an image all the way down to the bottom of the resist. As can be seen on comparison between Fig. 8A and Fig. 8B, the focus-intensity-drilling exposure process of the present disclosure allows feature formation and sidewall angle control over a greater range of dose and focus values. The range of dose and focus values across which sidewall angle can be controlled may itself be varied by using different values of focal position and/or intensity (e.g. using exposures having different ratios of focal position and/or intensity for different sub-exposures and/or different locations through the illumination region). In the example of Fig. 8A, the sidewall angle varies from about 95° to about 90°. In the example of Fig. 8B, the sidewall angle varies from about 97° to about 91°. That is, the focus-intensity-drilling exposure process of the present disclosure also allows a greater range of sidewall angles to be achieved. This enables greater control during the post-exposure etching processes to achieve the desired critical dimension and sidewall angle on the substrate (e.g. in silicon). It will be appreciated that the examples of Fig. 8A and Fig. 8B represent a proof of principle, and that greater improvements may be achieved in other (e.g. more optimized) exposures.

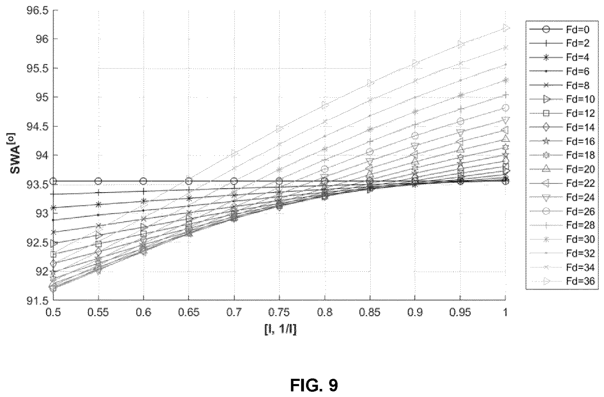

Fig. 9 shows an example of how sidewall angle may be controlled using the focus-intensity-drilling technique of the present disclosure. The y axis shows sidewall angle value in degrees, the x axis shows different ratios of intensity used during different focus-intensity-drilling exposure processes, and the different lines correspond to different separations in focal positon for two-level focus drilling exposures. As can be seen from Fig. 9, a large range of sidewall angle (e.g. from about 91.75° to about 96.25°) can be achieved by varying the focal position values and intensity values.

Varying focal position and/or intensity from field to field across the substrate W and/or within a single field allows variation of the sidewall angle across the substrate W. For example, the method of the present disclosure may comprise performing a second exposure process comprising projecting a second image of a second feature in the vicinity of the substrate. The method may comprise adjusting a focal position of the second image relative to the top surface of the substrate during the second exposure process. The method may comprise adjusting an intensity of the second image during the second exposure process. The intensity of the image and/or the intensity of the second image may be adjusted to apply different sidewall angles to the feature and the second feature on the substrate.

Varying focal position and/or intensity to control sidewall angle may be used to account for the non-uniform nature of post-exposure processes such as, for example etching. The intensity of the image may be adjusted during the exposure in at least partial dependence upon an expected effect of a post-exposure substrate processing step. For example, some etching processes may involve a radial non-uniformity. In this case, a counteracting radial variation of sidewall angle may be introduced using the focus-intensity-drilling exposure process of the present disclosure to at least partially account for the expected radial non-uniformity of the post-exposure etching process.

Optical simulation software may be used to determine the adjustment to the intensity of the image and/or the focal position needed to achieve a desired outcome (e.g. a desired sidewall angle). For example, HyperLith ^{®} by Panoramic Technology may be used to simulate the effects of different adjustments to focal position and intensity in the focus-intensity-drilling exposure process of the present disclosure. Once a desired outcome has been reached (e.g. a desired sidewall angle) a lithographic exposure may be performed using the values of focal position and intensity adjustments used in the simulation.

Some embodiments of the present disclosure relate to a lithographic apparatus that is operable to perform at least one of the methods 100, 140 shown in Figures 3A and 3B. The lithographic apparatus may, for example, be generally of the form of the lithographic apparatus LA shown in Figure 1 and described above (and may comprise any of the features thereof).

In some embodiments, the lithographic apparatus LA may comprise an illumination system IL comprising: a first optical component 10; a second optical component 11; and a controller CN. The first optical component 10 may comprise a two-dimensional array of independently movable reflective optical elements which is arranged to receive radiation B from a radiation source SO. The second optical component 11 may comprise a two-dimensional array of independently movable reflective optical elements and may be arranged to receive radiation B from the first optical component 10 and to direct it to an illumination region IR.

The controller CN may be operable to control the first and second optical components 10, 11. In particular, the controller CN may be operable to control the first and second optical components 10, 11 so as to illuminate the illumination region IR.

In some embodiments, each of the independently movable reflective optical elements of the first optical component 10 may comprise a micro-electromechanical system (MEMS) micro-mirror. For such embodiments, the first optical component 10 may be considered to comprise a MEMS micro-mirror array.

In some embodiments, each of the independently movable reflective optical elements of the second optical component 11 may comprise a micro-electromechanical system (MEMS) micro-mirror. For such embodiments, the second optical component 11 may be considered to comprise a MEMS micro-mirror array.

The lithographic apparatus LA may comprising a support structure MT configured to support a patterning device MA such that the patterning device MA is disposed in, or is movable through, the illumination region IR.

The lithographic apparatus may comprise: a substrate table WT configured to support a substrate W; and a projection system PS comprising imaging optics 13, 14 configured to receive radiation B' from the illumination region IR and to form an image of an object MA disposed in the illumination region IR on a substrate W supported by the substrate table WT.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of forming a feature on a substrate, the method comprising:
performing an exposure process comprising projecting an image of the feature in the vicinity of the substrate;
adjusting a focal position of the image relative to a top surface of the substrate during the exposure process; and
adjusting an intensity of the image during the exposure process.

2. The method of claim 1, wherein the intensity of the image is adjusted in at least partial dependence upon the adjustment to the focal position.

3. The method of claim 1 or claim 2, wherein adjusting the focal position of the image relative to the top surface of the substrate during the exposure process comprises:
projecting the image at a first focal position; and,
projecting the image at a second focal position that is different to the first focal position,
wherein adjusting the intensity of the image during the exposure process comprises:
applying a first intensity at the first focal position; and,
applying a second intensity at the second focal position that is different to the first intensity.

4. The method of claim 3, wherein:
the second focal position is closer to the top surface of the substrate than the first focal position; and,
the second intensity is greater than the first intensity.

5. The method of claim 3, wherein:
the second focal position is closer to the top surface of the substrate than the first focal position; and,
the second intensity is less than the first intensity.

6. The method of any preceding claim, wherein:
adjusting a focal position of the image relative to the top surface of the substrate during the exposure process comprises forming an illumination region having a variable focal position profile;
adjusting an intensity of the image during the exposure process comprises forming the illumination region having a variable intensity profile; and,
performing the exposure process comprises performing a single exposure through the illumination region.

7. The method of any of claims 1 to 5, wherein the exposure process comprises performing a plurality of sequential exposures, each of the plurality of exposures comprising projecting an image of the feature in the vicinity of the substrate;
wherein the focal position of the image relative to the top surface of the substrate is different for at least two of the plurality of exposures;
where there is a range of focal positions of the image relative to the top surface of the substrate that is not used during any of the plurality of exposures and which lies between the focal positions of the image relative to the top surface of the substrate for the two of the plurality of exposures; and,
wherein the intensity of the image is different for the at least two of the plurality of exposures.

8. The method of claim 7, wherein two sequential exposures are performed.

9. The method of any preceding claim, wherein performing the exposure process comprises:
illuminating a patterning device with radiation;
capturing radiation scattered from the patterning device with imaging optics; and
projecting the scattered radiation onto the substrate so as to form an image of the patterning device in the vicinity of the substrate.

10. The method of any preceding claim, wherein the intensity of the image is adjusted to control a profile of the feature on the substrate.

11. The method of any preceding claim, wherein the intensity of the image is adjusted to control a sidewall angle of the feature on the substrate.

12. The method of claim 10, wherein the intensity of the image is adjusted to reduce a variation of the sidewall angle of the feature on the substrate.

13. The method of claim 10 or claim 11, wherein the intensity of the image is adjusted in at least partial dependence upon an expected effect of a post-exposure substrate processing step.

14. The method of any of claims 10 to 12, wherein the method further comprises:
performing a second exposure process comprising projecting a second image of a second feature in the vicinity of the substrate;
adjusting a focal position of the second image relative to the top surface of the substrate during the second exposure process; and
adjusting an intensity of the second image during the second exposure process,
wherein the intensity of the image and/or the intensity of the second image is adjusted to apply different sidewall angles to the feature and the second feature on the substrate.

15. The method of any preceding claim, wherein the intensity of the image is adjusted to:
increase a minimum normalized image log-slope of the image of the feature in the vicinity of the substrate,
and/or
reduce a variation of a normalized image log-slope of the image of the feature in the vicinity of the substrate.

16. The method of any of claims 10 to 14, comprising using optical simulation software to determine the adjustment to the intensity of the image.

17. The method of any preceding claim, wherein the feature comprises an isolated feature.

18. The method of any preceding claim, wherein the intensity of the image is adjusted in at least partial dependence on:
a thickness of a photoresist applied to the substrate; and,
an absorption coefficient of the photoresist applied to the substrate.

19. The method of any preceding claim, wherein the substrate comprises a semiconductor.

20. A lithographic apparatus operable to perform the method of any preceding claim.

21. The lithographic apparatus of claim 20, comprising an illumination system comprising:
a first optical component comprising a two-dimensional array of independently movable reflective optical elements which is arranged to receive radiation from a radiation source; and,
a second optical component comprising a two-dimensional array of independently movable reflective optical elements and which is arranged to receive radiation from the first optical component and to direct it to an illumination region,
wherein the lithographic apparatus is operable to control the first and second optical components to contribute to performing the method of any of claims 1 to 19.

22. The lithographic apparatus of claim 21, wherein each of the independently movable reflective optical elements of the first optical component comprises a micro-electromechanical system (MEMS) micro-mirror.

23. The lithographic apparatus of claim 21 or claim 22, wherein each of the independently movable reflective optical elements of the second optical component comprises a micro-electromechanical system (MEMS) micro-mirror.

24. The lithographic apparatus of any of claims 21 to 23, further comprising a support structure configured to support a patterning device such that the patterning device is disposed in, or is movable through, the illumination region.

25. The lithographic apparatus of any of claims 21 to 24, further comprising: a substrate table configured to support a substrate; and a projection system comprising imaging optics configured to receive radiation from the illumination region and to form an image of an object disposed in the illumination region on a substrate supported by the substrate table.
